# EUROPÄISCHE PATENTSCHRIFT

(11) **EP 2 951 332 B1**
(45) Veröffentlichungstag und Bekanntmachung des Hinweises auf die Patenterteilung: **31.05.2017**
(21) Anmeldenummer: 14708784.5
(22) Anmeldetag: 29.01.2014
(51) Int. Cl.: B22F 1/00, B22F 3/02, B22F 3/12, B22F 3/15, B22F 9/04, B22F 9/08, C22C 30/02, H01J 37/34, H01L 31/18, B22F 3/105, C23C 14/34, C22C 24/00, C22C 28/00, C22C 9/00, C22C 1/04

(54) **Sputtertarget mit Ga-Na, In-Na oder Ga-In-Na intermetallischen Phasen**
Sputter target with Ga-Na, In-Na or Ga-In-Na intermetallic phases
Cible avec Ga-Na, In-Na ou Ga-In-Na en phase intermétallique

(30) Priorität: 31.01.2013 AT 262013 U
(43) Veröffentlichungstag der Anmeldung: 09.12.2015
(73) Patentinhaber: Plansee SE, 6600 Reutte (AT)
(72) Erfinder: LINKE, Christian, A-6600 Ehenbichl (AT); LI, Jiehua, A-8700 Leoben (AT); SCHUMACHER, Peter, A-8700 Leoben (AT); KNABL, Wolfram, A-6600 Reutte (AT); LEICHTFRIED, Gerhard, A-6600 Reutte (AT)
(74) Vertreter: Ciesla, Bettina
(86) Internationale Anmeldenummer: PCT/AT2014/000016
(87) Internationale Veröffentlichungsnummer: WO 2014/117190

(56) Entgegenhaltungen:
- WO-A1-2012/147985
- CN-A- 101 820 024
- JP-A- 2012 082 498

## Beschreibung

Die Erfindung betrifft ein Sputtertarget aus einer Legierung die aus 5 bis 70at% mindestens eines Elements der Gruppe (Ga, In), sowie 0,1 bis 15at% Na, dem Rest Cu sowie üblichen Verunreinigungen besteht. Weiterhin betrifft die Erfindung ein Verfahren zur Herstellung eines Sputtertargets sowie seine Verwendung. Photoaktive Schichten für Dünnschichtsolarzellen werden über Verfahren der physikalischen Dampfabscheidung (physical vapor deposition = PVD) hergestellt. Dabei handelt es sich um ein Verfahren zur Beschichtung, bei dem die Schichtbildung durch Verdampfen der schichtbildenden Teilchen aus einem Target und der Kondensation dieses Dampfes auf dem zu beschichtenden Substrat stattfindet. Ziel des Verfahrens ist es, homogene Schichten mit gleichmäßiger Schichtdicke abzuscheiden.

Für dieserart hergestellte photoaktive Schichten für Solarzellen auf CIGS-Basis werden Sputtertargets aus Cu-Ga, Cu-In sowie Cu-In-Ga eingesetzt. Derartige Sputtertargets können sowohl auf schmelzmetallurgischem Weg als auch über die pulvermetallurgische Herstellroute erzeugt werden.

Schmelzmetallurgisch hergestellte Sputtertargets zeigen den Nachteil eines groben Gefüges, das beim Sputterprozess zu einer Reliefbildung durch ungleichmäßigen Abtrag führt. Diesem Problem kann durch eine pulvermetallurgische Herstellroute entgegengewirkt werden. Pulvermetallurgisch hergestellte Sputtertargets zeigen eine sehr homogene, feinkörnige Mikrostruktur, die in weiterer Folge gleichmäßigen Abtrag beim Sputtern und eine optimierte dünne Schicht gewährleistet. Die schmelzmetallurgische Herstellung von Cu-In-Ga-Sputtertargets ist zum Beispiel in der EP 1 932 939 beschrieben, die pulvermetallurgische Herstellung von Cu-Ga-Sputtertargets offenbart beispielsweise die WO 2011 126092. Das Sputtertarget von JP2012082498 beinhaltet Na. Der in Dünnschichtsolarzellen auf CIGS-Basis erreichbare Wirkungsgrad wird durch die Zugabe von Alkalimetallen erhöht, wie zum Beispiel aus Contreras et al., 26th IEEE PVSC, Anaheim, California, Sep. 30-Oct. 3 (1997) 359-362 bekannt ist. Dabei erweist sich besonders Na, vor K und Cs als vorteilhaft. Die Erhöhung des Wirkungsgrades beruht nach allgemeinem Literaturverständnis auf einer Erhöhung der p-Typ Leitfähigkeit in der CIGS-Schicht sowie infolgedessen der Leerlaufspannung.

Die Einbringung von Alkaliatomen in die CIGS-Schicht der Dünnschichtsolarzelle kann über die Einbringung von alkalihaltigen Salzen oder organischen Verbindungen in ein zur Abscheidung der Schicht verwendetes Target erfolgen (US 2010 0258191*,* EP 2 410 556, WO 2011 055537). Dabei handelt es sich zum Beispiel um Cu-Ga-Targets mit einem entsprechenden Anteil einer organischen Alkaliverbindung oder eines Alkalisalzes.

Nachteil einer derartigen Einbringung von Alkaliatomen ist eine Verunreinigung durch die verwendeten organischen Bestandteile bzw. Kationen der verwendeten Salze, die in weiterer Folge zu einer Verminderung der Homogenität der Mikrostruktur sowie der Dichte des Targets führt. Dadurch wird auch die Qualität der abgeschiedenen Schicht reduziert und das erwünschte optimale Sputterergebnis nicht erzielt. Außerdem führt die geringere chemische Stabilität solcher Alkaliverbindungen zu Materialverlusten während des Herstellprozesses und demzufolge zu Schwankungen der Zusammensetzung der so erzeugten Sputtertargets. In weiterer Folge entstehen so auch unerwünschte und leistungsreduzierende Inhomogenitäten in mit solchen Sputtertargets abgeschiedenen Schichten. Die Bearbeitung und Lagerung von über die Einbringung von organischen Bestandteilen und oder Salzen hergestellten Sputtertargets birgt weitere Nachteile. So kann beispielsweise durch die hygroskopischen Eigenschaften der eingebrachten Salze eine erhöhte Korrosionsneigung des Targets verursacht werden, folglich können solcherart hergestellte Targets nur trocken bearbeitet werden.

Die Aufgabenstellung der Erfindung ist es, ein Sputtertarget aus einer Cu-Ga-Naeiner Cu-In-Na- oder einer Cu-Ga-In-Na-Legierung unter Vermeidung der erwähnten Nachteile herzustellen. Insbesondere soll ein erfindungsgemäßes Sputtertarget mit hohem Reinheitsgrad, das ein homogenes und feinkörniges Gefüge aufweist bereitgestellt werden. Das erfindungsgemäße Sputtertarget soll kostengünstig herstellbar, gut zu bearbeiten und zu handhaben, sowie ohne die Zugabe von organischen Verbindungen oder Salzen zu realisieren sein.

Gelöst wird die Aufgabe durch die unabhängigen Ansprüche. Vorteilhafte Ausgestaltungen ergeben sich aus den abhängigen Ansprüchen.

Das erfindungsgemäße Sputtertarget aus einer Legierung die aus 5 bis 70at% mindestens eines Elements der Gruppe (Ga, In), sowie 0,1 bis 15at% Na, dem Rest Cu sowie üblichen Verunreinigungen besteht, zeichnet sich dadurch aus, dass es zumindest eine intermetallische Na-enthaltende Phase beinhaltet. Durch die Einbringung mindestens einer intermetallischen Na-enthaltenden Phase wird bevorzugt vollständig auf die Verwendung von Salzen oder organischen Verbindungen als Na-Träger verzichtet. Dadurch wird der Reinheitsgrad des Sputtertargets erhöht und infolgedessen auch das Sputterergebnis verbessert.

Mit dem Begriff intermetallische Phasen werden Phasen bezeichnet, die in binären, ternären oder auch Mehrstoffsystemen auftreten und deren Existenzbereich sich nicht bis zu den reinen Komponenten fortsetzt. Sie besitzen häufig von den Kristallstrukturen der reinen Komponenten abweichende Kristallstrukturen sowie Anteile nichtmetallischer Bindungstypen. Intermetallische Phasen sind vor allem durch eine wertigkeitsfremde Zusammensetzung und einen endlichen Homogenitätsbereich gekennzeichnet. Intermetallische Phasen besitzen häufig eine hohe Festigkeit sowie eine gute Korrosionsbeständigkeit.

Mit üblichen Verunreinigungen werden herstellbedingte Verunreinigungen an Gasen oder begleitenden Elementen bezeichnet, die aus den verwendeten Rohstoffen stammen. Der Anteil solcher Verunreinigungen in einem erfindungsgemäßen Sputtertarget liegt im Bereich von unter 1000 ppm für Gase, sowie unter 500 ppm für andere Elemente.

Die mindestens eine Na-enthaltende intermetallische Phase im erfindungsgemäßen Sputtertarget stammt bevorzugt aus der Gruppe der intermetallischen Ga-Na-Phasen, der intermetallischen In-Na-Phasen oder der intermetallischen Ga-In-Na-Phasen. Diese Phasen sind deswegen bevorzugt einzusetzen, da sie aufgrund ihrer unter etwa 550°C liegenden Schmelzpunkte günstige Herstellbedingungen über die schmelzmetallurgische Route möglich machen.

Die mindestens eine Na-enthaltende intermetallische Phase im erfindungsgemäßen Sputtertarget stammt bevorzugt aus der Gruppe NaGa₄, Na₅Ga₈, Na₇Ga₁₃, Na₂₂Ga₃₉, Naln, Na₂In, Na₇In₁₂, Na₁₅In₂₇ und Na₁₇Ga₂₉In₁₂, wobei auch weitere binäre intermetallische Ga-Na-Phasen, In-Na-Phasen, ternäre intermetallische Ga-In-Na-Phasen sowie intermetallische Ungleichgewichtsphasen aus den Systemen Ga-Na, In-Na, sowie Ga-In-Na Verwendung finden können, deren chemische Zusammensetzung einer naturgemäßen geringen Schwankungsbreite unterliegen kann. Alle diese intermetallischen Phasen sind dadurch gekennzeichnet, dass sie eine enge stöchiometrische Zusammensetzung aufweisen. Zusätzlich wird durch die naturgemäß starken Bindungen intermetallischer Phasen gewährleistet, dass während des Herstellprozesses nur geringe Na-Verluste auftreten. Demzufolge kann der im Sputtertarget erwünschte Na-Gehalt genau eingestellt werden.

Das Auftreten intermetallischer Phasen im Gefüge des erfindungsgemäßen Sputtertargets kann sehr einfach mittels Röntgendiffraktometrie unter Verwendung der JCPDS-Karten für die jeweiligen intermetallischen Phasen nachgewiesen werden.

Besonders vorteilhaft ist die Wirkung der Na-enthaltenden intermetallische Phase wenn diese im Gefüge des Sputtertargets homogen verteilt in einer Matrix aus zumindest einem Element der Gruppe (Cu, Ga, In) eingebettet vorliegt. Vorteilhaft ist weiter eine annähernd globulare Form der vorliegenden Na-enthaltenden intermetallischen Phase. Durch ein solcherart ausgestaltetes Gefüge ist die Na-Verteilung im gesamten Sputtertarget gleichmäßig, und führt in weiterer Folge auch zu einer optimierten Na-Verteilung in der damit hergestellten Schicht. Die annähernd globulare Form der intermetallischen Phasen wirkt sich positiv auf die Zähigkeit des Sputtertargets aus, da dadurch nur eine geringe Kerbwirkung ausgeübt wird. Als Phasen mit globularer Form werden hier dreidimensional annähernd kugelförmige Partikel definiert, die in mindestens einem zweidimensionalen Schnitt, beispielsweise an einer Schlifffläche, ein Aspektverhältnis von 0,7 bis 1,3 aufweisen.

Weiter positiv auf das Sputterverhalten des erfindungsgemäßen Sputtertargets wirkt sich eine Größe der intermetallischen Phasen zwischen 1 und 500 µm, bevorzugt zwischen 1 und 200 µm aus. Durch diese Feinkörnigkeit der intermetallischen Phasen wird ein gleichmäßiger Abtrag ohne Reliefbildung beim Sputtern gewährleistet. Besonders vorteilhaft tritt dieser Effekt bei einer Größe der intermetallischen Phasen zwischen 1 und 50 µm in Erscheinung.

Das erfindungsgemäße Sputtertarget weist weiters eine relative Dichte von mehr als 90% auf. Besonders vorteilhaft ist eine noch höhere relative Dichte von mehr als 96%. Weiter bevorzugt ist eine relative Dichte von mehr als 98%. Je höher die Dichte des Targets umso vorteilhafter sind dessen Eigenschaften. Unter einer relativen Dichte von 96% liegt eine teilweise offenporiges Gefüge vor, welches ein virtuelles Leck und oder Quelle von Verunreinigungen und Partikeln sein kann. Außerdem neigen Targets mit geringer Dichte dazu, Wasser sowie andere Verunreinigungen aufzunehmen, was infolgedessen zu schwer kontrollierbaren Prozessparametern führen kann.

Die relative Dichte kann bekanntlich einfach über das archimedische Prinzip mittels Auftriebsverfahren bestimmt werden.

Das erfindungsgemäße Sputtertarget weist bevorzugt einen Cu-Gehalt von mehr als 30at% auf. Cu-Gehalte bis zu 94,5at% sind in Ausführungsformen der Erfindung möglich. Cu-Gehalte von weniger als 30at% führen zu einer stark verringerten Zähigkeit des Sputtertargets, die eine produktionstechnische und kundenseitige Handhabung erschwert.

In Ausführungsformen der Erfindung, die sowohl Ga als auch In enthalten, liegt der bevorzugte Cu-Gehalt zwischen 30 und 50at%. Durch Sputtern eines erfindungsgemäßen Sputtertargets mit Cu-Gehalten in diesem Bereich können CIGS-Schichten mit besonders vorteilhaften Eigenschaften erzeugt werden.

Der Gehalt des mindestens einen Elements der Gruppe (Ga, In) in einem erfindungsgemäßen Sputtertarget liegt zwischen 5 und 70at%, in bevorzugten Ausführungsformen zwischen 20 und 65at%. Bei Gehalten von über 70at% ist eine problemlose Handhabung auf Grund zu geringer Zähigkeit und des zusätzlich niedrigen Schmelzpunktes von auftretenden Cu-Ga-Phasen nicht mehr gewährleistet, unter 5at% kann durch Sputtern des Sputtertargets keine Schicht mit günstigen photoaktiven Eigenschaften mehr hergestellt werden. Eine Einschränkung auf unter 65at% verbessert die Handhabung weiter. Die weiter vorteilhafte Einschränkung auf Gehalte des mindestens einen Elements der Gruppe (Ga, In) von mindestens 20at% ist dadurch begründet, dass die technische Wirkweise von mittels Sputtern des erfindungsgemäßen Sputtertarget hergestellten photoaktiven Schichten damit optimiert werden kann.

In Ausführungsformen der Erfindung, die sowohl Ga als auch In enthalten, erweist sich ein Verhältnis in at% der Bestandteile Ga/(Ga+In) zwischen 0,15 und 0,35 als besonders vorteilhaft. Bei einem Verhältnis der Bestandteile Ga/(Ga+In) kleiner 0,15 kann die für die optimale Wirkweise notwendige Stöchiometrie der mittels Sputtern des Sputtertargets hergestellten photoaktiven Schicht ungünstig beeinflusst werden. Verhältnisse Ga/(Ga+In) von größer 0,35 führen zu einer verminderten Zähigkeit des Sputtertargets.

Der bevorzugte Na-Gehalt des erfindungsgemäßen Sputtertargets liegt zwischen 0,1 und 15at%. Dadurch können in die mittels Sputtern abgeschiedene photoaktive Schicht bevorzugt zwischen 0,1 und 3at% Na eingebracht und infolgedessen der Wirkungsgrad der so erzeugten Dünnschichtsolarzelle signifikant gesteigert werden. Optimiert wird diese Wirkung noch durch einen bevorzugten Na-Gehalt des erfindungsgemäßen Sputtertargets zwischen 1 und 5at%.

Durch die vorgesehene Verwendung zur Abscheidung von photoaktiven Schichten für Dünnschichtsolarzellen in unterschiedlichen Fertigungsanlagen sowie für unterschiedliche Geometrien der zu beschichtenden Substrate werden verschiedene geometrische Anforderungen an ein erfindungsgemäßes Sputtertarget gestellt. Demzufolge kann ein solches in Form einer Platte, einer Scheibe, einer Stange, eines Rohrs oder eines anderen komplex geformten Körpers vorliegen. Ein solcher komplex geformter Körper kann beispielsweise die Form eines Topfes oder einer Hohlkathode aufweisen.

Ein erfindungsgemäßes Sputtertarget kann über die pulvermetallurgische Route hergestellt werden, die über das Bereitstellen einer Pulvermischung und nachfolgendes Kompaktieren führt.

Hier erweist es sich als besonders vorteilhaft, wenn ein Verfahren zur Herstellung eines erfindungsgemäßen Sputtertargets folgenden Schritt enthält:
- Herstellung eines Vorlegierungspulvers das mindestens eine Na-enthaltende intermetallische Phase enthält.

Durch die Herstellung eines Vorlegierungspulvers, das mindestens eine Na-enthaltende intermetallische Phase enthält, wird gewährleistet, dass der Na-Gehalt des Sputtertargets genau eingestellt werden kann. Dies resultiert zum einen aus der engen stöchiometrischen Zusammensetzung der verwendeten intermetallischen Phasen, als auch aus der hohen Bindungsstärke intermetallischer Phasen, die Na-Verluste sowohl bei der Herstellung als auch bei der Verwendung des Sputtertargets verhindert.

Die Herstellung des Vorlegierungspulvers, das mindestens eine Na-enthaltende intermetallische Phase enthält, kann durch Verdüsen einer Ga-Na-, einer In-Na- oder einer Ga-In-Na-Schmelze durchgeführt werden. Die schmelzmetallurgisch hergestellten Legierungen weisen bevorzugt Schmelzpunkte von <550°C auf und können somit mit herkömmlichen Gasverdüsungsverfahren hergestellt werden. Nach dem Verdüsen liegt das Vorlegierungspulver in Pulverkorngrößen bevorzugt zwischen 1 und 100µm und annähernd sphärischer Form vor. Das Vorlegierungspulver kann nach dem Verdüsen weiters gesiebt, gesichtet, klassiert und oder weiter zerkleinert werden.

Das Vorlegierungspulver, das mindestens eine Na-enthaltende intermetallische Phase enthält, kann alternativ auch durch Herstellung eines Ingots aus einer Ga-Na-, einer In-Na- oder einer Ga-In-Na-Schmelze und nachfolgendem Zerkleinern und oder Mahlen hergestellt werden. Die geringe Zähigkeit intermetallischer Phasen gewährleistet ein gutes Mahlergebnis mit einer engen Verteilung der resultierenden Pulverkorngröße des Vorlegierungspulvers.

Ein erfindungsgemäßes Vorlegierungspulver ist dadurch gekennzeichnet, dass es mindestens eine Na-enthaltende intermetallische Phase enthält. Diese intermetallische Phase stammt bevorzugt aus der Gruppe der intermetallischen Ga-Na-Phasen, der intermetallischen In-Na-Phasen oder der intermetallischen Ga-In-Na-Phasen. Diese Phasen sind deswegen bevorzugt einzusetzen, da sie aufgrund ihrer unter etwa 550°C liegenden Schmelzpunkte günstige Herstellbedingungen des Vorlegierungspulvers über die schmelzmetallurgische Route möglich machen.

Weiters bevorzugt stammt die intermetallische Phase im erfindungsgemäßen Vorlegierungspulver aus der Gruppe NaGa₄, Na₅Ga₈, Na₇Ga₁₃, Na₂₂Ga₃₉, Naln, Na₂In, Na₇In₁₂, Na₁₅In₂₇ und Na₁₇Ga₂₉In₁₂, wobei auch weitere binäre intermetallische Ga-Na-Phasen, In-Na-Phasen, ternäre intermetallische Ga-In-Na-Phasen sowie intermetallische Ungleichgewichtsphasen aus den Systemen Ga-Na, In-Na, sowie Ga-In-Na Verwendung finden können, deren chemische Zusammensetzung einer naturgemäßen geringen Schwankungsbreite unterliegen kann. Alle diese intermetallischen Phasen sind dadurch gekennzeichnet, dass sie eine enge stöchiometrische Zusammensetzung aufweisen. Zusätzlich wird durch die naturgemäß starken Bindungen intermetallischer Phasen gewährleistet, dass während des Herstellprozesses nur geringe Na-Verluste auftreten. Demzufolge kann der im Vorlegierungspulver erwünschte Na-Gehalt genau eingestellt werden.

Das Auftreten dieser intermetallischer Phasen in einem erfindungsgemäßen Vorlegierungspulver kann sehr einfach mittels Röntgendiffraktometrie unter Verwendung der JCPDS-Karten für die jeweiligen intermetallischen Phasen nachgewiesen werden.

In Ausführungsformen der Erfindung kann das mindestens eine Na-enthaltende intermetallische Phase enthaltende Vorlegierungspulver bevorzugt vollständig aus Na-enthaltender intermetallischer Phase bestehen.

Ein erfindungsgemäßes Vorlegierungspulver wird bevorzugt zur Herstellung eines Sputtertargets verwendet.

Das Verfahren zur Herstellung eines erfindungsgemäßen Sputtertargets enthält bevorzugt weitere folgende Schritte:
- Herstellung einer das Vorlegierungspulver enthaltenden Pulvermischung
- Einfüllen der Pulvermischung in eine Form

Eine das Vorlegierungspulver enthaltende Pulvermischung wird durch das Mischen des Vorlegierungspulvers mit entsprechenden Mengen an Ga, In und Cu enthaltenden Pulvern erreicht. So kann die chemische Zusammensetzung des erfindungsgemäßen Sputtertargets genau und unkompliziert eingestellt werden. Durch den Verzicht an organischen Verbindungen und Salzen werden Verluste während des Herstellprozesses, die durch die Zersetzung dieser Verbindungen entstehen, weitestgehend vermieden. Somit können effizienter höhere Na-Gehalte in das erzeugte Sputtertarget eingebracht werden. In weiterer Folge werden durch die höhere Stabilität der intermetallischen Na-enthaltenden Phasen auch Verluste während des Einsatzes des Sputtertargets beim Sputtern weitgehend vermieden und Inhomogenitäten und Verunreinigungen in einer mit einem erfindungsgemäß hergestellten Sputtertarget durch Sputtern erzeugten Schicht reduziert. Auch die Handhabung, Bearbeitung und Lagerung des erfindungsgemäßen Sputtertargets werden durch die reduzierte Korrosionsneigung deutlich verbessert.

Die derart hergestellte Pulvermischung wird in eine Form gefüllt. Als Form werden hier sowohl die Matrize oder der Schlauch einer kaltisostatischen Presse, einer Heißpresse oder einer Spark-Plasma-Sinteranlage sowie auch die Kanne einer heißisostatischen Presse bezeichnet.

Das Verfahren zur Herstellung eines erfindungsgemäßen Sputtertargets enthält bevorzugt weiteren folgenden Schritt:
- Kompaktieren der Pulvermischung durch die Anwendung von Druck, Temperatur oder Druck und Temperatur zu einem Rohling

Die in eine Form gefüllte Pulvermischung wird durch die Anwendung von Druck, Temperatur oder Druck und Temperatur zu einem Rohling kompaktiert. Dies kann durch verschieden ausgestaltete Prozessschritte erfolgen, beispielsweise durch Pressen und Sintern, Heißpressen, Kaltisostatischpressen, Heißisostatischpressen oder Spark Plasma Sintern (SPS) oder eine Kombination daraus.

Das Verfahren zur Herstellung eines erfindungsgemäßen Sputtertargets enthält bevorzugt weiteren folgenden Schritt:
- Umformen des Rohlings zum Beispiel durch Strangpressen, Schmieden oder Walzen

Der erhaltene Rohling kann im Folgenden umgeformt werden um gegebenenfalls vorteilhafte Eigenschaften wie zum Beispiel eine Erhöhung der Dichte und oder eine weitere Homogenisierung des Gefüges zu erzeugen. Als geeignete Verfahren für eine Umformung stellen sich zum Beispiel Walzen, Schmieden oder Strangpressen dar.

Das Verfahren zur Herstellung eines erfindungsgemäßen Sputtertargets enthält bevorzugt weiteren folgenden Schritt:
- Wärmebehandlung

Sowohl nach dem Kompaktieren durch Druck, Temperatur oder Druck und Temperatur, als auch nach einem gegebenenfalls durchgeführten Umformschritt kann eine Wärmebehandlung des Rohlings vorteilhaft sein. Je nach chemischer Zusammensetzung des Sputtertargets können die dabei angewandten Temperaturen in einem bevorzugten Bereich von 50 bis 500°C liegen, ebenso kann die Wirkung einer solchen Wärmebehandlung von einem ausschließlichen Abbau von Spannungen bis hin zu Gefügeveränderungen durch Wanderung von Klein- und oder Großwinkelkorngrenzen führen. Auch das Auftreten von Phasenumwandlungen kann durch eine solche Wärmebehandlung erreicht werden.

Das Verfahren zur Herstellung eines erfindungsgemäßen Sputtertargets enthält bevorzugt weiteren folgenden Schritt:
- Mechanische Bearbeitung

Um die erwünschte Endgeometrie und Oberflächengüte des erfindungsgemäßen Sputtertargets zu erzielen, können weiters mechanische Bearbeitungsschritte, zum Beispiel Zerspanen, Schleifen, Polieren, erfolgen. Diese Bearbeitungsschritte können durch die Vermeidung von Salzen sowie organischen Verbindungen im Herstellprozess sowohl als Trocken- als auch als Nassbearbeitungsschritte gestaltet werden.

Das erfindungsgemäße Target kann weiters mittels eines Verbindungsprozesses, insbesondere Löten, Kleben oder Bonden, auf mindestens ein Stützelement, insbesondere in Form einer Platte oder eines Rohrs aufgebracht werden.

Im Folgenden wird die Erfindung an Hand von Herstellungsbeispielen und Figuren näher erläutert.

### AUSFÜHRUNGSBEISPIELE

Die Ausführungsbeispiele sind in Tabelle 1 zusammengefasst.

**Tabelle 1:**

| **Beispiel** | **Cu** | **Ga** | **In [at%]** | **Na** | **Pulverroute Kompaktieren** | | **Form / Target** |
|---|---|---|---|---|---|---|---|
| 1 | 72 | 27 | 0 | 1 | Ga/Na 75/25, Schmelzen bei 200°C, Abguss bei 600°C, Ingot; Cu/Ga Pulver 75/25 | uniaxiale Heisspresse, 400°C | Scheibe, Smm, 100mm |
| 2 | 64 | 31 | 0 | 5 | Ga/Na 65/35, Schmelzen bei 200°C, Abguss bei 600°C, Ingot; Cu/Ga Pulver 75/25 | bei 300°C Kanne entgasen, HIP bei 450°C und 100MPa | Rohr, 155/135x250mm |
| 3 | 68 | 31 | 0 | 1 | Ga/Na 65/35, Schmelzen bei 200°C, Verdüsen bei 600°C, Cu/Ga Pulver 70/30 | Heißpresse SPS 400°C | Scheibe, 5mm, 100mm |
| 4 | 40 | 15 | 40 | 5 | Ga/Na 75/25, Schmelzen bei 200°C, Abguss bei 600°C, Ingot; Cu/In Pulver 50/50 | CIP | Scheibe, 5mm, 100mm |
| 5 | 73 | 26 | 0 | 1 | Ga/Na 65/35, Schmelzen bei 200°C, Abguss bei 600°C, Ingot; Cu/Ga Pulver 75/25 | bei 300°C Kanne entgasen, HIP bei 450°C und 100MPa | Zylindrisch, Strangpresse 10x50mm, zweiteilige Scheibe 100mm |
| 6 | 78 | 0 | 21 | 1 | In/Na 55/45, Schmelzen bei 300°C, Abguss bei 500°C, Ingot; Cu/In Pulver 80/20 | uniaxiale Heisspresse, 400°C | Scheibe, 5mm, 100mm |
| 7 | 64 | 0 | 31 | 5 | In/Na 40/60, Schmelzen bei 300°C, Verdüsen bei 500°C; Cu/In Pulver 70/30 | evakuieren, HIP bei 400°C und 100MPa | Rohr, 155/135x250mm |
| 8 | 41 | 17 | 37 | 5 | Ga/In/Na 50/20/30, Schmelzen bei 250 °C, Abguss bei 550°C; Ingot; Cu/In/Ga Pulver | Heißpresse SPS 400°C | Scheibe, 5mm, 100mm |
| 9 | 42 | 8 | 45 | 5 | Ga/In/Na 50/20/30, Schmelzen bei 250 °C, Abguss bei 550°C; Ingot; Cu/In Pulver 50/50 | evakuieren, HIP bei 450°C und 100MPa | Rohr, 155/135x250mm |

### Beispiel 1:

1 kg Ga wurde in einem Grafittiegel mittels Induktionserwärmung auf 200°C erwärmt und aufgeschmolzen. Anschließend erfolgte die Zugabe von 0,1 kg Na (Verhältnis in at% Ga/Na = 75/25). Die Temperatur wurde anschließend auf 600°C erhöht. Nach dem vollständigen Erschmelzen erfolgte der Abguss der Legierung in eine Kokille aus Warmarbeitsstahl.

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene Ga-Na-Vorlegierungspulver auf eine Größe von <500 µm abgesiebt und mit gasverdüstem Cu-Ga-Legierungspulver (Ga-Gehalt 25at%) vermischt, sodass ein Na-Gehalt von 1 at% eingestellt wurde.

Die so erhaltene Cu-Ga-Na-Pulvermischung wurde in einer uniaxialen Heißpresse bei einer Temperatur von 400°C zu einer Scheibe kompaktiert und anschließend zu einem Sputtertarget mit einer Stärke von 5 mm und einem Durchmesser von 100 mm fertig bearbeitet.

### Beispiel 2:

5 kg Ga wurden in einem Grafittiegel mittel Induktionserwärmung auf 200°C erwärmt und aufgeschmolzen. Anschließend erfolgte die Zugabe von 0,9 kg Na (Verhältnis in at% Ga/Na = 65/35). Die Temperatur wurde dabei auf 600°C erhöht. Nach dem vollständigen Erschmelzen erfolgte der Abguss der Legierung in eine Kokille aus Warmarbeitsstahl

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene Ga-Na-Vorlegierungspulver auf eine Größe von <500 µm abgesiebt und mit gasverdüstem Cu-Ga-Legierungspulver (Ga-Gehalt 25at%) vermischt, sodass ein Na-Gehalt von 5 at% eingestellt wurde.

Die so erhaltene Cu-Ga-Na-Pulvermischung wurde in eine rohrförmige Stahlkapsel eingefüllt, bei 300°C heißentgast und luftdicht verschweißt. Das Kompaktieren des Pulvers erfolgte mittels Heißisostatischpressen bei einer Temperatur von 450°C, einem Druck von 100 MPa.

Der so erhaltene Rohling wurde anschließend über eine mechanische Drehbearbeitung zu einem rohrförmigen Sputtertarget von 155/135x250 mm bearbeitet.

### Beispiel 3:

5 kg Ga wurden in einem Grafittiegel mittels Induktionserwärmung auf 200°C in einer Ar-Schutzgasatmosphäre erwärmt und aufgeschmolzen. Anschließend erfolgte die Zugabe von 0,9 kg Na (Verhältnis in at% Ga/Na = 65/35). Die Temperatur wurde dabei auf 600°C erhöht. Nach dem vollständigen Erschmelzen der Legierung erfolgte das Verdüsen mittels Ar-Gas zu einem sphärischen Vorlegierungspulver.

Nachfolgend wurde das so erhaltene Vorlegierungspulver mit ebenfalls gasverdüstem Cu-Ga-Legierungspulver (Ga-Gehalt 30at%) zu einer Cu-Ga-Na-Pulvermischung mit einem Na-Gehalt von 1at% vermischt.

Die so erhaltene Cu-Ga-Na-Pulvermischung wurde an einer uniaxialen Heißpresse mittels Spark Plasma Sintern (SPS) bei einer Temperatur von 400°C zu einer Scheibe kompaktiert und anschließend zu einem scheibenförmigen Sputtertarget mit einer Stärke von 5 mm und einem Durchmesser von 100 mm fertig bearbeitet.

### Beispiel 4:

1 kg Ga wurde in einem Grafittiegel mittels Induktionserwärmung auf 200°C erwärmt und aufgeschmolzen. Anschließend erfolgte die Zugabe von 0,1 kg Na (Verhältnis in at% Ga/Na = 75/25). Die Temperatur wurde anschließend auf 600°C erhöht. Nach dem vollständigen Erschmelzen erfolgte der Abguss der Legierung in eine Kokille aus Warmarbeitsstahl.

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene Ga-Na-Vorlegierungspulver auf <500µm abgesiebt und mit gasverdüstem Cu-In-Legierungspulver (Verhältnis in at% Cu/In = 50/50) zu einer Pulvermischung mit einem Na-Gehalt von 5at% vermischt.

Die so erhaltene Cu-Ga-In-Na-Pulvermischung wurde anschließend auf einer 3000 t Presse uniaxial bei Raumtemperatur zu einem scheibenförmigen Rohling kompaktiert. Der so erhaltene Rohling wurde in Folge zu einem Sputtertarget mit einer Stärke von 5 mm und einem Durchmesser von 100 mm fertig bearbeitet.

### Beispiel 5:

5 kg Ga wurden in einem Grafittiegel mittels Induktionserwärmung auf 200°C erwärmt und aufgeschmolzen. Anschließend erfolgte die Zugabe von 0,9 kg Na (Verhältnis in at% Ga/Na = 65/35). Die Temperatur wurde dabei auf 600°C erhöht. Nach dem vollständigen Erschmelzen erfolgte der Abguss der Legierung in eine Kokille aus Warmarbeitsstahl.

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene Ga-Na-Vorlegierungspulver auf eine Teilchengröße von <500 µm abgesiebt und mit gasverdüstem Cu-Ga-Legierungspulver (Ga-Gehalt 25at%) zu einer Pulvermischung mit einem Na-Gehalt von 1at% vermischt.

Die so erhaltene Cu-Ga-Na-Pulvermischung wurde in eine zylindrische Stahlkapsel eingefüllt, bei 300°C heißentgast und luftdicht verschweißt. Das Kompaktieren des Pulvers erfolgte mittels Heißisostatischpressen (HIP) bei einer Temperatur von 450°C und einem Druck von 100 MPa.

Der so erhaltene zylindrische Rohling wurde nachfolgend mittels einer mechanischen Drehbearbeitung von der Stahlkanne getrennt und auf einen Durchmesser von 60 mm und eine Länge von 70 mm bearbeitet.

Der zylindrische Rohling wurde anschließend in einem Durchschubofen auf 800°C erwärmt und mit einer 100 t Strangpresse zu einem Rechteckprofil 10x50 mm stranggepresst. Daraus wurde ein zweiteiliges Target mit einem Durchmesser von 100 mm gefertigt.

### Beispiel 6:

5 kg In wurden in einem Grafittiegel mittels Induktionserwärmung auf 300°C erwärmt und aufgeschmolzen. Anschließend erfolgte die Zugabe von 0,8 kg Na (Verhältnis in at% In/Na = 55/45). Die Temperatur wurde dabei auf 500°C erhöht.

Nach dem vollständigen Erschmelzen erfolgte der Abguss der Legierung in eine Kokille aus Warmarbeitsstahl.

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene In-Na-Vorlegierungspulver auf eine Teilchengröße von <500 µm abgesiebt und mit gasverdüstem Cu-In-Legierungspulver (In-Gehalt 20at%) zu einer Pulvermischung mit einem Na-Gehalt von 1at% vermischt.

Die so erhaltene Cu-In-Na-Pulvermischung wurde in einer uniaxialen Heißpresse bei einer Temperatur von 400°C zu einer Scheibe kompaktiert und anschließend zu einem Sputtertarget mit einer Stärke von 5 mm und einem Durchmesser von 100 mm fertig bearbeitet.

### Beispiel 7

5 kg In wurden in einem Grafittiegel mittels Induktionserwärmung auf 300°C in einer Ar-Schutzgasatmosphäre erwärmt und aufgeschmolzen. Anschließend erfolgte die Zugabe von 1,15 kg Na (Verhältnis in at% In/Na = 40/60). Die Temperatur wurde dabei auf 500°C erhöht. Nach dem vollständigen Erschmelzen der Legierung erfolgte das Verdüsen mittels Ar-Gas zu einem sphärischen Vorlegierungspulver.

Nachfolgend wurde das so erhaltene Vorlegierungspulver mit ebenfalls gasverdüstem Cu-In-Legierungspulver (In-Gehalt 30at%) zu einer Cu-In-Na-Pulvermischung mit einem Na-Gehalt von 5 at% vermischt.

Die so erhaltene Cu-In-Na-Pulvermischung wurde in eine rohrförmige Stahlkapsel eingefüllt, evakuiert und luftdicht verschweißt. Das Kompaktieren des Pulvers erfolgte mittels Heißisostatischpressen bei einer Temperatur von 400°C und einem Druck von 100 MPa.

Der so erhaltene Rohling wurde anschließend über eine mechanische Drehbearbeitung zu einem rohrförmigen Sputtertarget von 155/135x250 mm bearbeitet.

### Beispiel 8

5,5 kg Ga und 3,5 kg In wurden in einem Grafittiegel mittels Induktionserwärmung auf 250°C erwärmt und aufgeschmolzen. Anschließend erfolgte die Zugabe von 0,1 kg Na (Verhältnis in at% Ga/In/Na = 50/20/30). Die Temperatur wurde dabei auf 550°C erhöht. Nach dem vollständigen Erschmelzen erfolgte der Abguss der Legierung in eine Kokille aus Warmarbeitsstahl.

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene Ga-In-Na-Vorlegierungspulver auf eine Teilchengröße von <500 µm abgesiebt und mit gasverdüstem Cu-In-Ga-Legierungspulver (Ga Gehalt 10at%, In-Gehalt 40at%) zu einer Pulvermischung mit einem Na-Gehalt von 5at% vermischt.

Die so erhaltene Cu-Ga-In-Na-Pulvermischung wurde an einer uniaxialen Heißpresse mittels Spark Plasma Sintern (SPS) bei einer Temperatur von 400°C zu einer Scheibe kompaktiert und anschließend zu einem scheibenförmigen Sputtertarget mit einer Stärke von 5 mm und einem Durchmesser von 100 mm fertig bearbeitet.

### Beispiel 9

5,5 kg Ga und 3,5 kg In wurden in einem Grafittiegel mittels Induktionserwärmung auf 250°C erwärmt und aufgeschmolzen. Anschließend erfolgte die Zugabe von 0,1 kg Na (Verhältnis in at% Ga/In/Na = 50/20/30). Die Temperatur wurde dabei auf 550°C erhöht. Nach dem vollständigen Erschmelzen erfolgte der Abguss der Legierung in eine Kokille aus Warmarbeitsstahl.

Der so hergestellte Ingot wurde nach dem Erstarren entnommen und nach dem vollständigen Abkühlen mit Hilfe eines Backenbrechers und einer Schlagkreuzmühle zerkleinert.

In Folge wurde das so erhaltene Ga-In-Na-Vorlegierungspulver auf eine Teilchengröße von <500 µm abgesiebt und mit gasverdüstem Cu-In-Legierungspulver (In-Gehalt 50at%) zu einer Pulvermischung mit einem Na-Gehalt von 5at% vermischt.

Die so erhaltene Cu-Ga-In-Na-Pulvermischung wurde in eine rohrförmige Stahlkapsel eingefüllt, evakuiert und luftdicht verschweißt. Das Kompaktieren des Pulvers erfolgte mittels Heißisostatischpressen bei einer Temperatur von 450°C und einem Druck von 100 MPa.

Der so erhaltene Rohling wurde anschließend über eine mechanische Drehbearbeitung zu einem rohrförmigen Sputtertarget von 155/135x250 mm bearbeitet.

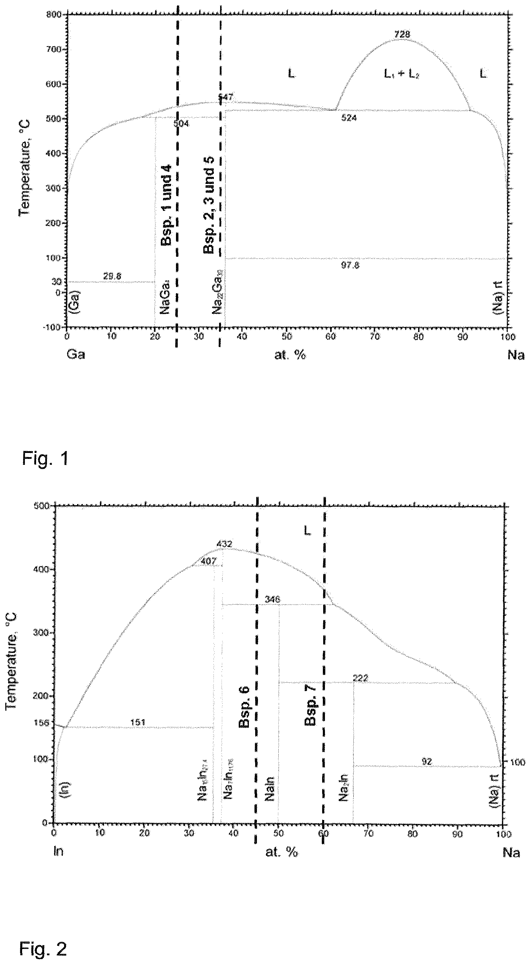

Figur 1: Phasendiagramm des Ga-Na Systems [*ASM Phase Diagrams Center, Diagramm No. 103346*]; Zusammensetzungen der Vorlegierungspulver der Beispiele 1 bis 5 markiert.
Figur 2: Phasendiagramm des In-Na Systems [*ASM Phase Diagrams Center, Diagramm No. 903718*]; Zusammensetzungen der Vorlegierungspulver der Beispiele 6 und 7 markiert.

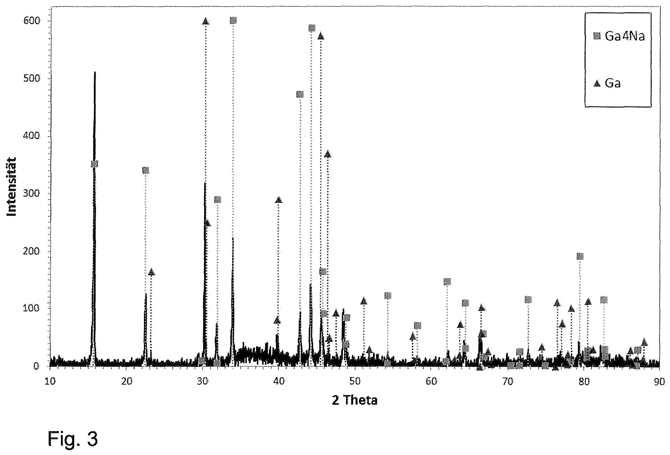

Figur 3: Röntgendiffraktogramm zu Beispiel 3, Verwendete JCPDS-Karten für Ga *Nummer 03-065-2492*, für Ga₄N *Nummer 00-043-1375*.

## Patentansprüche

1. Sputtertarget aus einer Legierung die aus 5 bis 70at% mindestens eines Elements der Gruppe (Ga, In), sowie 0,1 bis 15at% Na, dem Rest Cu sowie üblichen Verunreinigungen besteht, **dadurch gekennzeichnet, dass** das Sputtertarget mindestens eine intermetallische Na-enthaltende Phase beinhaltet.

2. Sputtertarget nach Anspruch 1, **dadurch gekennzeichnet, dass** die mindestens eine intermetallische Na-enthaltende Phase aus der Gruppe der intermetallischen Ga-Na-Phasen, der intermetallischen In-Na-Phasen und der intermetallischen Ga-In-Na-Phasen stammt.

3. Sputtertarget nach einem der vorangehenden Ansprüche, **dadurch gekennzeichnet, dass** die mindestens eine Na-enthaltende intermetallische Phase aus der Gruppe NaGa₄, Na₅Ga₈, Na₇Ga₁₃, Na₂₂Ga₃₉, Naln, Na₂In, Na₇In₁₂, Na₁₅In₂₇ und Na₁₇Ga₂₉In₁₂ stammt.

4. Sputtertarget nach einem der vorangehenden Ansprüche, **dadurch gekennzeichnet, dass** die Na-enthaltende intermetallische Phase homogen verteilt in einer Matrix aus zumindest einem Element der Gruppe (Cu, Ga, In) eingebettet vorliegt.

5. Sputtertarget nach einem der vorangehenden Ansprüche, **dadurch gekennzeichnet, dass** es mehr als 30at% Cu enthält.

6. Sputtertarget nach einem der vorangehenden Ansprüche, **dadurch gekennzeichnet, dass** der Gehalt des mindestens einen Elements der Gruppe (Ga, In) zwischen 20 und 65at% liegt.

7. Sputtertarget nach einem der vorangehenden Ansprüche, **dadurch gekennzeichnet, dass** das Verhältnis in at% der Bestandteile Ga/(Ga+In) zwischen 0,15 und 0,35 liegt.

8. Sputtertarget nach einem der vorangehenden Ansprüche, **dadurch gekennzeichnet, dass** es zwischen 1 und 5at% Na enthält.

9. Sputtertarget nach einem der vorangehenden Ansprüche, **dadurch gekennzeichnet, dass** es in Form einer Platte, einer Scheibe, einer Stange, eines Rohrs oder eines anderen komplex geformten Körpers vorliegt.

10. Verwendung eines Sputtertargets nach einem der vorangehenden Ansprüche zur Abscheidung einer photoaktiven Schicht für eine Dünnschichtsolarzelle.

11. Verfahren zu Herstellung eines Sputtertargets, **dadurch gekennzeichnet, dass** dieses folgenden Schritt enthält:
- Herstellung eines Vorlegierungspulvers das mindestens eine Na-enthaltende intermetallische Phase enthält.

12. Verfahren zur Herstellung eines Sputtertargets nach Anspruch 11, **dadurch gekennzeichnet, dass** es folgende weitere Schritte enthält:
- Herstellung einer das Vorlegierungspulver enthaltenden Pulvermischung
- Einfüllen der Pulvermischung in eine Form

13. Verfahren zur Herstellung eines Sputtertargets nach Anspruch 11 oder 12, **dadurch gekennzeichnet, dass** es folgenden weiteren Schritt enthält:
- Kompaktieren der Pulvermischung durch die Anwendung von Druck, Temperatur oder Druck und Temperatur zu einem Rohling

14. Verfahren zur Herstellung eines Sputtertargets nach einem der Ansprüche 11 bis 13, **dadurch gekennzeichnet, dass** es folgenden weiteren Schritt enthält:
- Umformen des Rohlings zum Beispiel durch Strangpressen, Schmieden oder Walzen

15. Verfahren zur Herstellung eines Sputtertargets nach einem der Ansprüche 11 bis 14, **dadurch gekennzeichnet, dass** es folgenden weiteren Schritt enthält:
- Wärmebehandlung

16. Verfahren zur Herstellung eines Sputtertargets nach einem der Ansprüche 11 bis 15, **dadurch gekennzeichnet, dass** es folgenden weiteren Schritt enthält:
- Mechanische Bearbeitung

17. Verfahren zur Herstellung eines Sputtertargets nach einem der Ansprüche 11 bis 16, **dadurch gekennzeichnet, dass** das mindestens eine Na-enthaltende intermetallische Phase enthaltende Vorlegierungspulver über Verdüsen einer Ga-Na-, In-Na- oder Ga-In-Na-Schmelze hergestellt wird.

18. Verfahren zur Herstellung eines Sputtertargets nach einem der Ansprüche 11 bis 16, **dadurch gekennzeichnet, dass** das mindestens eine Na-enthaltende intermetallische Phase enthaltende Vorlegierungspulver über die Herstellung eines Ingots aus einer Ga-Na-, einer In-Na- oder einer Ga-In-Na-Schmelze und nachfolgendem Zerkleinern und oder Mahlen hergestellt wird.

19. Vorlegierungspulver, **dadurch gekennzeichnet, dass** es mindestens eine Na-enthaltende intermetallische Phase aus der Gruppe der intermetallischen Ga-Na-Phasen, der intermetallischen In-Na-Phasen oder der intermetallischen Ga-In-Na-Phasen enthält und das Vorlegierungspulver in Pulverkorngrößen zwischen 1 und 100 µm und annähernd sphärischer Form vorliegt.

20. Verwendung eines Vorlegierungspulvers nach Anspruch 19 zur Herstellung eines Sputtertargets.

## Claims

1. Sputtering target composed of an alloy consisting of 5 to 70at% of at least one element from the group of (Ga, In) and 0.1 to 15at% of Na, the remainder being Cu and typical impurities, **characterized in that** the sputtering target comprises at least one intermetallic Na-containing phase.

2. Sputtering target according to Claim 1, **characterized in that** the at least one intermetallic Na-containing phase is from the group of the intermetallic Ga-Na phases, the intermetallic In-Na phases and the intermetallic Ga-In-Na phases.

3. Sputtering target according to either of the preceding claims, **characterized in that** the at least one Na-containing intermetallic phase is from the group of NaGa₄, Na₅Ga₈, Na₇Ga₁₃, Na₂₂Ga₃₉, Naln, Na₂In, Na₇In₁₂, Na₁₅In₂₇ and Na₁₇Ga₂₉In₁₂.

4. Sputtering target according to any of the preceding claims, **characterized in that** the Na-containing intermetallic phase is present embedded in homogeneous distribution in a matrix of at least one element from the group of (Cu, Ga, In).

5. Sputtering target according to any of the preceding claims, **characterized in that** it contains more than 30at% of Cu.

6. Sputtering target according to any of the preceding claims, **characterized in that** the content of the at least one element from the group of (Ga, In) is between 20 and 65at%.

7. Sputtering target according to any of the preceding claims, **characterized in that** the ratio in at% of the constituents Ga/(Ga+In) is between 0.15 and 0.35.

8. Sputtering target according to any of the preceding claims, **characterized in that** it contains between 1 and 5at% of Na.

9. Sputtering target according to any of the preceding claims, **characterized in that** it is in the form of a plate, a disc, a rod, a tube or another body of complex shape.

10. Use of a sputtering target according to any of the preceding claims for deposition of a photoactive layer for a thin-film solar cell.

11. Process for producing a sputtering target, **characterized in that** it comprises the following step:
- producing a preliminary alloy powder comprising at least one Na-containing intermetallic phase.

12. Process for producing a sputtering target according to Claim 11, **characterized in that** it comprises the following further steps:
- producing a powder mixture comprising the preliminary alloy powder
- introducing the powder mixture into a mould.

13. Process for producing a sputtering target according to Claim 11 or 12, **characterized in that** it comprises the following further step:
- compacting the powder mixture by the application of pressure, temperature, or pressure and temperature, to give a blank.

14. Process for producing a sputtering target according to any of Claims 11 to 13, **characterized in that** it comprises the following further step:
- forming the blank, for example by extrusion, forging or rolling.

15. Process for producing a sputtering target according to any of Claims 11 to 14, **characterized in that** it comprises the following further step:
- heat treatment.

16. Process for producing a sputtering target according to any of Claims 11 to 15, **characterized in that** it comprises the following further step:
- mechanical processing.

17. Process for producing a sputtering target according to any of Claims 11 to 16, **characterized in that** the preliminary alloy powder comprising at least one Na-containing intermetallic phase is produced via atomization of a Ga-Na, In-Na or Ga-In-Na melt.

18. Process for producing a sputtering target according to any of Claims 11 to 16, **characterized in that** the preliminary alloy powder comprising at least one Na-containing intermetallic phase is produced via the production of an ingot from a Ga-Na, an In-Na or a Ga-In-Na melt and subsequent comminution and/or milling.

19. Preliminary alloy powder, **characterized in that** it comprises at least one Na-containing intermetallic phase from the group of the intermetallic Ga-Na phases, the intermetallic In-Na phases or the intermetallic Ga-In-Na phases and **in that** the preliminary alloy powder is present in powder particle sizes between 1 and 100 µm and in approximately spherical form.

20. Use of a preliminary alloy powder according to Claim 19 for production of a sputtering target.

## Revendications

1. Cible de pulvérisation composée d'un alliage, qui est constitué de 5 à 70 % d'at. au moins d'un élément du groupe (Ga, In) ainsi que de 0,1 à 15 % d'at. de Na, du reste de Cu ainsi que des impuretés habituelles, **caractérisée en ce que** la cible de pulvérisation comporte une phase contenant du Na intermétallique.

2. Cible de pulvérisation selon la revendication 1, **caractérisée en ce que** l'au moins une phase contenant du Na intermétallique provient du groupe des phases de Ga-Na intermétalliques, des phases de In-Na intermétalliques et des phases de Ga-In-Na intermétalliques.

3. Cible de pulvérisation selon l'une quelconque des revendications, **caractérisée en ce que** l'au moins une phase intermétallique contenant du Na provient du groupe comprenant NaGa4, Na₅Ga₈, Na₇Ga₁₃, Na₂₂Ga₃₉, NaIn, Na₂In, Na₇In₁₂, Na₁₅In₂₇ et Na₁₇Ga₂₉In₁₂.

4. Cible de pulvérisation selon l'une quelconque des revendications précédentes, **caractérisée en ce que** la phase intermétallique contenant du Na est incorporée selon une répartition homogène incorporée dans une matrice composée au moins d'un élément du groupe (Cu, Ga, In).

5. Cible de pulvérisation selon l'une quelconque des revendications précédentes, **caractérisée en ce qu'**elle contient plus de 30 % d'at. de Cu.

6. Cible de pulvérisation selon l'une quelconque des revendications précédentes, **caractérisée en ce que** la teneur de l'au moins un élément du groupe (Ga, In) est comprise entre 20 et 65 % d'at.

7. Cible de pulvérisation selon l'une quelconque des revendications précédentes, **caractérisée en ce que** le rapport en % d'at. des constituants Ga/(Ga+In) est compris entre 0,15 et 0,35.

8. Cible de pulvérisation selon l'une quelconque des revendications précédentes, **caractérisée en ce qu'**elle contient entre 1 et 5 % d'at. de Na.

9. Cible de pulvérisation selon l'une quelconque des revendications précédentes, **caractérisée en ce qu'**elle est présente sous la forme d'une plaque, d'un disque, d'une tige, d'un tuyau ou d'un autre corps à forme complexe.

10. Utilisation d'une cible de pulvérisation selon l'une quelconque des revendications précédentes servant à séparer une couche photoactive pour une cellule solaire à couche mince.

11. Procédé servant à fabriquer une cible de pulvérisation, **caractérisé en ce qu'**il contient l'étape qui suit consistant à :
- fabriquer une poudre d'alliage mère, qui contient au moins une phase intermétallique contenant du Na.

12. Procédé servant à fabriquer une cible de pulvérisation selon la revendication 11, **caractérisé en ce qu'**il contient des étapes supplémentaires qui suivent consistant à :
- fabriquer un mélange de poudres contenant la poudre d'alliage mère ;
- transvaser le mélange de poudres dans un moule.

13. Procédé servant à fabriquer une cible de pulvérisation selon la revendication 11 ou 12, **caractérisé en ce qu'**il contient l'étape supplémentaire qui suit consistant à :
- compacter le mélange de poudres par l'application d'une pression, d'une température ou d'une pression et de température pour obtenir une ébauche.

14. Procédé servant à fabriquer une cible de pulvérisation selon l'une quelconque des revendications 11 à 13, **caractérisé en ce qu'**il contient l'étape supplémentaire qui suit consistant à :
- mettre en forme l'ébauche par exemple par extrusion, forgeage ou laminage.

15. Procédé servant à fabriquer une cible de pulvérisation selon l'une quelconque des revendications 11 à 14, **caractérisé en ce qu'**il contient l'étape supplémentaire qui suit consistant à :
- traiter à chaud.

16. Procédé servant à fabriquer une cible de pulvérisation selon l'une quelconque des revendications 11 à 15, **caractérisé en ce qu'**il contient l'étape supplémentaire qui suit consistant à :
- usiner mécaniquement.

17. Procédé servant à fabriquer une cible de pulvérisation selon l'une quelconque des revendications 11 à 16, **caractérisé en ce que** l'au moins une poudre d'alliage mère contenant une phase intermétallique contenant du Na est fabriquée par l'atomisation d'une matière fondue de Ga-Na, de In-Na ou de Ga-In-Na.

18. Procédé servant à fabriquer une cible de pulvérisation selon l'une quelconque des revendications 11 à 16, **caractérisé en ce que** l'au moins une poudre d'alliage mère contenant une phase intermétallique contenant du Na est fabriquée par la fabrication d'un lingot composé d'une matière fondue de Ga-Na, d'une matière fondue de In-Na ou d'une matière fondue de Ga-In-Na et est fabriquée par la suite par fragmentation ou par broyage.

19. Poudre d'alliage mère, **caractérisée en ce qu'**elle contient au moins une phase intermétallique contenant du Na issue du groupe des phases de Ga-Na intermétalliques, des phases de In-Na intermétalliques ou des phases de Ga-In-Na intermétalliques, et **en ce que** la poudre d'alliage mère est présente sous des granulométries de poudre comprises entre 1 et 100 µm et sous une forme approximativement sphérique.

20. Utilisation d'une poudre d'alliage mère selon la revendication 19 servant à fabriquer une cible de pulvérisation.
